(19) Europäisches Patentamt
European Patent Office
Office européen des brevets

(11) EP 2 141 503 A1

(12) EUROPEAN PATENT APPLICATION

(43) Date of publication:
06.01.2010 Bulletin 2010/01

(51) Int Cl.:
G01R 1/073 (2006.01)     G01R 27/14 (2006.01)

(21) Application number: 08388023.7

(22) Date of filing: 30.06.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(71) Applicant: Capres A/S
2800 Lyngby (DK)

(72) Inventor: Petersen, Dirch Hjorth
2870 Dyssegård (DK)

(74) Representative: Nielsen, Henrik Sten et al
Budde Schou A/S
Vester Søgade 10
1601 Copenhagen V (DK)

(54) **A multi-point probe for testing electrical properties and a method of producing a multi-point probe**

(57)     A multi-point probe for testing electrical properties of a number of specific locations of a test sample comprises a supporting body defining a first surface, a first multitude of conductive probe arms (101-101'''), each of the probe arms defining a proximal end and a distal end. The probe arms are connected to the supporting body (105) at the proximal ends, and the distal ends are freely extending from the supporting body, giving individually flexible motion to the probe arms. The probe arms together with the supporting body define lines of contact between each of the probe arms and the supporting body and each of the lines of contact defines a perpendicular bisector being parallel to the first surface. The conductive probe arms originate from a process of producing the multi-point probe including producing the conductive probe arms on the supporting wafer body in facial contact with the supporting wafer body and removal of a part of the wafer body providing the supporting body and providing the conductive probe arms freely extending from the supporting body. Each of the probe arms defines a maximum width perpendicular to its perpendicular bisector and parallel with its line of contact with the supporting body, and a maximum thickness perpendicular to its perpendicular bisector and its line of contact with the supporting body. The maximum width and the maximum thickness define a ratio in the range of 0.5-20, such as 1-10, preferably 1-3, and each of the probe arms has a specific area or point of contact (111-111''') at its distal end for contacting a specific location among the number of specific locations of the test sample. At least one of the probe arms has an extension defining a pointing distal end providing its specific area or point of contact located offset relative to its perpendicular bisector.

fig 5

**Description**

The present invention generally relates to a technique for testing electric properties on a specific location of a test sample, and in particular the technique of probing and analyzing surface layers and multilayered structures. More specifically, the present invention relates to a multi-point probe, a multi-point testing apparatus and a method of producing a multi-point probe.

Microscopic four-point or multi-point probes are a well known and established technique employed for testing the electric properties of a test sample. A conventional four-point probe typically has the specific area or point of contact of each probe arm laying in an in-line configuration with the corresponding specific areas or points of contact of the other probe arms. The probe arms are usually straight, unidirectional and symmetrical around their centre axes, e.g. by having the same rectangular or circular cross-sections along the lengthwise extending centre axes.

Multi-point probes and the corresponding methods and systems for determining electrical properties of test samples have been described in publications such as EP1095282B1, US 7,304,486 and US 7,323,890. Reference is made to the above US patents, which are hereby incorporated in the present specification by reference.

Conventionally, an external positioning system places the four-point probe into physical contact with a test sample by moving the four-point probe in a perpendicular motion relative surface of the test sample. A surface of a test sample may be uneven and a force perpendicular to the surface has to be applied to the four-point probe, in order to ensure that all the specific areas or points of contact are connected as desired. As a result of an uneven test surface, the force from each specific area or point of contact on the surface may vary between the probe arms. The multi-point probes in the related art have several operative constraints when reduced in scale. The probe-arm distances and widths become smaller, where the latter in particular presents some critical scaling effects.

If the vectors $e_x$, $e_y$ and $e_z$ form an orthonormal basis, where $e_x$ is parallel to the centre axes and $e_z$ is perpendicular to the plane formed by the unidirectional probe arms, the probe arms have the length $L \cdot e_x$, the width $w \cdot e_y$, and the height $h \cdot e_z$. Due to the size and shape of the multi-point probe, the probe arms need to be of a certain length, to avoid any point of the supporting body of the probe encountering the sample surface before the probe arms.

There are in principle three critical scaling effects resulting from the narrowing of the probe arms. Firstly, the flexibility, which can be represented by a spring constant when modelling, will decrease. In the y-direction parallel to $e_y$ the spring constant scales with $k_y \sim w^3 h$, whereas in the z-direction parallel to $e_z$ it scales with $k_z \sim wh^3$. Thus, the lateral spring constant $k_y$ decreases much faster than $k_z$ when scaling down the width of the probe arms. In practise, this means that the probe arms will be soft and too flexible for an exact positioning and the areas or points of contact will be very poorly defined.

Secondly, the narrowing of the probe arms will increase the electrical and thermal resistance between the connecting leads and the tip of the probe arm, i.e. between the proximal and distal ends of the probe arms. For low noise measurements, a low electrical resistance of the probe arms, i.e. between the connecting leads and the specific area or point of contact, is a necessity. Further, if the thermal resistance is too high, the electrode material will be damaged or destroyed as a result of Joule heating causing electromigration and/or thermomigration.

Thirdly, when the volume of the probe arm decreases as a result of a reduced width and height, the heat capacity is reduced. Thereby, the probe arms ability to absorb heat or energy is decreased, which may result in overheating of the probe arms at short transient peak currents and subsequent malfunctioning of the probe arms.

The surface layer sensitivity of a measurement on the surface of a bi-layered (or multilayered) test sample depends on the probe-arm distance. At large distances between the specific areas or points of contact the current may pass through both the sample top layer, or surface layer, and the sample bottom layer(s), or substrate. However, if distances between the specific areas or points of contact are sufficiently small, the current will mainly pass through the sample top layer.

For the conventional multi-point probe as described above, the sensitivity is increased by decreasing the probe-arm distances. However, there is a lower probe-arm distance limit, which is estimated as the minimum probe-arm distance achievable, without experiencing the critical scaling effects described above. From experiments it has been found that the minimum probe-arm distance limit is on the order of 1 μm and that probes with a probe-arm distance smaller than 1 μm will experience the critical scaling effects. Note that the lower probe-arm distance limit is not sharp, but corresponds to a regime where the scaling effects gradually take effect. The object of this invention is to enable high-sensitivity measurements, without experiencing any severe scaling effects.

The above object, the above advantage and the above feature together with numerous other objects, advantages and features which will be evident from the below detailed description of a preferred embodiment of the present invention is according to a first aspect of the present invention obtained by a multi-point probe for testing electrical properties of a number of specific locations of a test sample, said multi-point probe comprising:

(a) a supporting body defining a first surface;
(b) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;

(c) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;

(d) each of said probe arms defining a maximum width perpendicular to its perpendicular bisector and parallel with its line of contact with said supporting body, and a maximum thickness perpendicular to its perpendicular bisector and its line of contact with said supporting body, said maximum width over said maximum thickness defining a ratio in the range of 0.5-20, such as 1-10, preferably 1-3, and each of said probe arms having a specific area or point of contact at its distal end for contacting a specific location among said number of specific locations of said test sample; and

(e) at least one of said probe arms having an extension defining a pointing distal end providing its specific area or point of contact located offset relative to its perpendicular bisector.

A maximum width over maximum thickness ratio in the range 0.5-20 may ensure balanced relationship between the spring constants involved in the flexing of the probe arms when measuring, especially with probe arm distances at the sub-micrometer scale. A small maximum width leads to a small spring constant in the lateral direction, i.e. the probe arm is easily flexed in a direction parallel to $\boldsymbol{e}_y$, which may result low accuracy in the placing of the specific area or point of contact on a test sample, especially on an uneven surface. This effect may be increased by having a large maximum thickness, since then more force has to be employed in order to ensure a good contact between the specific area or point of contact and a test sample for all probe-arms. Further, a large maximum width may lead to the specific areas or points of contact being placed far apart, which means a lower spatial resolution of the multi-point probe.

As the specific area or point of contact of a probe arm is located at its distal end, this implies that the extension is also located at its distal end. The specific area or point of contact of the probe arm having an extension is located offset relative to its perpendicular bisector. The offset may have a first offset component perpendicular to the perpendicular bisector and parallel to the line of contact, and/or a second offset component perpendicular to the perpendicular bisector and perpendicular to the line of contact. Further, the distance between the specific area or point of contact of the probe arm having an extension and the specific areas or point of contact of another probe arm may be decreased by the offset, which may be an advantage as it increases the spatial resolution of the multi-point probe.

Another probe arm of the multi-point probe may be located juxtaposed the one probe arm and having at its distal end a bevelled end face congruent with the extension of the one probe arm and defining a pointing distal end constituting its specific area or point of contact located closely spaced from the specific area or point of contact of the one probe arm. In a preferred embodiment the bevelled end face is oriented so that the width of the probe arm at its distal end decreases with an increased distance from its proximal end. Naturally, this will give a pointing distal end. The bevelled end face of a probe arm may also be interpreted as the probe arm having a chamfered end face, or having a relief or a cut so that the end face defines an angle to the perpendicular bisector when the probe arm is viewed from a direction perpendicular to both the perpendicular bisector and to the line of contact. In addition, the probe arm is not limited to have a single bevelled end face at its distal end, but it may have any number of such surfaces.

The one probe arm may correspond to the earlier described probe arm having an extension. In the present context, the expression congruent is preferably interpreted in its conventional form, i.e. that each of the one and the other probe arms has a side facing the other probe arm, and that the sides coincide if the probe arms are brought together. An alternative interpretation is that the extension of the one probe arm may have a geometrical shape that is congruent with the geometrical shape of the distal end of the other probe arm, i.e. the geometrical shapes are isometric in that they only differ by a rotation, a reflection and/or a translation. The extension congruent with the bevelled end face may, in a broader interpretation, correspond to a feature of the extension such that the distance between the one probe arm and the other probe arm is substantially constant, or that it changes less than half of the maximum width of either of the probe arms, when going from the proximal ends to the specific areas or points of contact of the probe arms.

The specific area or point of contact of the other probe arm may be located closely spaced from the specific area or point of contact of the one probe arm. This may be interpreted as the congruent extension having the property that it decreases the distance between the specific areas or points of contact of the probe arms involved. Clearly, this will bring the specific areas or points of contact of the probe arms closer to one another, which may be an advantage, since it may enable a higher spatial resolution of the multi-point probe.

The specific area or point of contact of the other probe may be located offset relative to its perpendicular bisector. This may be an advantage, as it may bring the specific area or point of contact of the other probe arm closer to the specific area or point of contact of the one probe arm, or closer to the specific area or point of contact of yet another probe arm. Naturally, this may be an advantage as it increases the spatial resolution of the multi-point probe.

At least one of the probe arms of the multi-point probe may have an elongated through-going aperture extending lengthwise and offset relative to its perpendicular bisector of the at least one probe arm for eliminating, to any substantial extent, any motion perpendicular to its perpendicular bisector and parallel to the first surface when flexibly moving it relative to the supporting body and moving the specific area or point of contact perpendicular to the first surface.

An offset of the specific area or point of contact of a probe arm relative to its perpendicular bisector may, when of a probe arm is employed in a measurement, cause the specific area or point of contact to move in a lateral direction parallel to its line of contact. This may be a disadvantage, as it results in a decrease in the accuracy of the placing of the specific areas or points of contact on a test sample, i.e. the spatial accuracy of a measurement decreases. However, the apertures may change the structural properties of the probe arm so that, when the probe arms is employed in a measurement, the lateral movement of the specific area or point of contact is substantially eliminated, even though a twisting moment may still present. Clearly, the aperture may increase the spatial accuracy of a measurement, which may be an advantage.

According to the basic realisation of the present invention, the multi-point probe according to the first aspect of the present invention is implemented in accordance with the technique of producing electronic circuits, in particular involving planar techniques as the probe is produced from a supporting body, originating from a wafer body on which a first multitude of conductive probe arms are produced involving deposition, accomplished by any technique known in the art, such as chemical vapour deposition (CVD), plasma enhanced CVD (PECVD), electron cyclotron resonance (ECR), focused ion beam (FIB) induced deposition or sputtering, chemical etching, plasma etching, focused ion beam (FIB) etching or any other production technique, for example high resolution lithographic methods such as UV lithography, electron-beam lithography, atomic force microscopy (AFM) lithography or laser lithography, whereupon a part of the original supporting body is removed through mechanical grinding or etching producing the freely extending conducting probe arms characteristic to the present invention constituting the test pins of multi-point probes according to the first aspect of the present invention.

The above part, which is removed from the original wafer body, producing the body supporting the conductive probe arms may constitute a minor part or a major part of the original wafer body and, the supporting body may according to alternative embodiments of the multi-point probe according to the present invention dimensionally constitute a minor part or a major part as compared to the freely extending part of the conductive probe arms.

The conductive probe arms characteristic to the multi-point probe according to the first aspect of the present invention according to the basic realisation of the present invention allow the contacting of the multi-point probe in an angular positioning of the conductive probe arms in relation to the surface of the test sample to be tested as distinct from the above described four-point probe, which is moved perpendicularly in relation to the surface of the test sample. The angular orientation of the conductive probe arms of the multi-point probe allows the flexible and elastically bendable conductive probe arms to contact any specific and intentional location of the test sample and establish a reliable electrical contact with the location in question.

The technique characteristic to the present invention of establishing the contact between the multi-point probe and the test locations of the test sample by utilising an angular positioning of the conductive probe arms in relation to the test sample for contacting in a bending or flexing of the conducting probe arms prevents the probe arms from mechanically destroying or deteriorating the test sample to be tested, which may be of crucial importance in specific applications such as thin film characterization, magnetic tunnel junction (MTJ) characterization, inter-layer contact resistivity characterization, LSI and VLSI circuitry.

As distinct from the prior art four-point probe arm, the multi-point probe according to the present invention including a first multitude of conductive probe arms may be configured in any appropriate configuration due to the utilisation of the production technique, allowing the conducting probe arms to be orientated in any mutual orientation in relation to one another and further in relation to the supporting body for complying with specific requirements such as a specific test sample to be tested. In this context, the particular feature of the present invention, namely the possibility of utilising a production technique compatible with the techniques used for producing electronic circuits, allows the multi-point probe to be readily configured in accordance with specific requirements through the utilisation of existing CAD/CAM techniques for micro-systems. However, according to the presently preferred embodiment of the multi-point probe according to the first aspect of the present invention, the first multitude of conductive probe arms are unidirectional constituting a multitude of parallel free extensions of the supporting body.

The first multitude of conductive probe arms of the multi-point probe according to the first aspect of the present invention has conductive probe arms that are unidirectional.

Further, the conductive probe arms define a first distance between the specific area or point of contact of a first probe arm of the conductive probe arms and the specific area or point of contact of a second probe arm of the conductive probe arms. The first and second probe arms further defines a second distance between the normal bisector of the first probe arm to the normal bisector of the second probe arm, which, together with the first distance, defines a pair of distances where the first distance is smaller than the second distance.

Three of the conductive probe arms of the multi-point probe according to the first aspect of the present invention are placed in a sequence on the supporting body and are separated by a first separation corresponding to a pair of distances and a second separation also corresponding to a pair of distances, where the first distance is smaller than the second distance in each of the first and second separations. The first distance of the first separation may be substantially the same as the first distance of the second separation, or the first distance of the first separation may be substantially different from the first distance of the second separation.

The first distance of the first separation may be in the ranges 10 nm to 120$\mu$m, 40nm to 60$\mu$m, 80nm to 30$\mu$m, and/or 160nm to 15$\mu$m, preferably 200nm, and the first distance of the second separation may also be in the ranges 10nm to 120$\mu$m, 40nm to 60$\mu$m, 80nm to 30$\mu$m, and/or 160nm to 15$\mu$m, preferably 200nm. Further, the first distance of the first separation may be in the range 10nm to 100nm, 100nm to 300nm, 300nm to 1$\mu$m, 1$\mu$m to 5$\mu$m, 5$\mu$m to 20$\mu$m, or 20$\mu$m to 120$\mu$m, and the first distance of the second separation may also be the range 10nm to 100nm, 100nm to 300nm, 300nm to 1$\mu$m, 1$\mu$m to 5$\mu$m, 5$\mu$m to 20$\mu$m, or 20$\mu$m to 120um.

Another of the conductive probe arms of the multi-point probe according to the first aspect of the present invention may be located in sequence with the sequence of three conductive probe arms and separated from the closest of the three conductive probe arms by a third separation corresponding to a pair of distances, the third separation having a first distance which is larger than both the first distance of the first separation and the first distance of the second separation.

The third separation may have a first distance which is larger than the first distance of the first and/or the second separation by factor in the ranges 2 to 1000, 5 to 800, 10 to 600, and/or 20 to 400, preferably 40. Further, the third separation may have a first distance which is larger than the first distance of the first and/or the second separation by factor in the ranges 3 to 10, 10 to 30, 30 to 90, 90 to 300, 300 to 1000, $10^3$ to $10^4$, $10^4$ to $10^5$, $10^5$ to $10^6$, $10^6$ to $10^7$, or $10^7$ to $10^8$. Furthermore, the fourth probe arm may be removed and replaced by any other means of electrically contacting the test sample, such as a sample back gate, eutectic contact, or clamp contact at any location on the test sample.

The first multitude of conductive probe arms on one surface of the multi-point probe according to the first aspect of the present invention has three or more conductive probe arms positioned on one surface as the presently preferred embodiment. Four conductive probe arms is the presently preferred number for a single measurement, while 12 is the presently preferred number for several measurements at different characteristic length scales. Application of a test signal to the surface of the test sample between any two of the four conductive probe arms provides a resultant test signal between the remaining two conductive probe arms, including information of the electric properties of the test sample.

The conductive probe arms of the multi-point probe according to the first aspect of the present invention are multilayered and define a top layer and a bottom layer for each of the probe arms, the bottom layer is connected to the supporting body, while the top layer is connected to the bottom layer and is located on the opposite side of the bottom layer from the supporting body. If all elongated through-going apertures are disregarded, each of the top layer and the bottom layer has a substantially rectangular cross section, thereby making it possible to define for each layer: the dimension of width as a distance between the lines of the rectangular cross section perpendicular to the plane of the first surface of the supporting body, the dimension of depth as a distance between the lines of the rectangular cross section parallel to the plane of the first surface of supporting body, and the dimension of length as a distance from the proximal end of the conductive probe arms to the distal end of the conductive probe arm.

Each of the conductive probe arms may have a depth of the top layer that is smaller than the depth of the bottom layer. Further, each of the conductive probe arms may have a width of the top layer that is larger than the width of the bottom layer. Further, each of the conductive probe arms may have a length of the top layer that is larger than the length of the bottom layer. The conductive probe arms may have a ratio of the length to the width of the bottom layer within the range of 500:1 to 2:1, such as ratios 50:1 and 5:1, a preferable application having the ratio of 10:1. Further, the conductive probe arms may have a ratio of the width to the depth of the bottom layer within the range of 20:1 to 1:5, preferable application having the ratio of 2:1.

At least one of said conductive probe arms of the multi-point probe according to the first aspect of the present invention has tapered elements at the distal end of the conductive probe arms. The tapered element may be multilayered and define a tapered top layer and a tapered bottom layer, which are extensions of the top layer and the bottom layer, respectively, of the conductive probe arm. Further, the specific area or point of contact of the conductive probe arm may be located at the tapered element.

At least one of the conductive probe arms of the multi-point probe according to the first aspect of the present invention has a pointed shaped element extending from an area, point or tapered element at the distal end of the conductive probe arms; and the specific area or point of contact of the conductive probe arm may be located on the tapered element or the extending element.

The first multitude of conductive probe arms of the multi-point probe according to the first aspect of the present invention have the lengths in the range of 100 nm to 2 mm, preferably a length of 10 $\mu$m.

The supporting body of the multi-point probe according to the first aspect of the present invention is of a ceramic material, and/or the supporting body is of a semiconducting material, and/or the supporting body is of a polymer material.

Preferably, the material comprises Si, Quartz, SU-8 or any combinations thereof. Use of the such materials or combinations thereof allows for the micro-fabrication in the manufacturing process of the multi-point probe, hence benefiting from the advantages of the micro-fabrication technology.

The bottom layer of the multi-point probe according to the first aspect of the present invention is a dielectric material or a semiconductor or a polymer. Preferably, the dielectric material or semiconductor or a polymer comprises $SiO_2$, $Si_xN_y$, Si or SU-8.

The probe arm top layer of the multi-point probe according to the first aspect of the present invention is a conducting layer. Alternatively, the top layer may comprise: a conducting layer and a carrying layer, the carrying layer being in contact with the bottom layer, while the conducting layer is connected to the carrying layer and is located on the opposite side of the carrying layer from the bottom layer. The conducting layer may comprise conductive materials, such as Au, Ag, Pt, Ni, Ta, Ti, Cr, Cu, Os, W, Mo, Ir, Pd, Cd, Re, conductive diamond, metal silicides, conducting ceramic, semiconductor material or any combinations thereof. The carrying layer may comprise dielectric materials, semiconducting materials, or metals or alloys, such as crystalline or poly-crystalline silicon, Ge, diamond, diamond-like carbon, SiC, $Si_xN_y$, SU-8, TiN, TiW, NiSi, $TiSi_2$, or $WSi_2$, preferably crystalline silicon.

The above object, the above advantage and the above feature, together with numerous other objects, advantages and features which will be evident from the below detailed description of a presently preferred embodiment of the present invention, are obtained, according to a second aspect of the present invention, by a multi-point testing apparatus for testing electric properties on a specific location of a test sample, comprising:

(i) means for receiving and supporting said test sample;
(ii) electric properties testing means including electric generator means for generating a test signal and electric measuring means for detecting a measuring signal;
(iii) a multi-point probe, comprising:

(a) a supporting body defining a first surface;
(b) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;
(c) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
(d) each of said probe arms defining a maximum width perpendicular to its perpendicular bisector and parallel with its line of contact with said supporting body, and a maximum thickness perpendicular to its perpendicular bisector and its line of contact with said supporting body, said maximum width and said maximum thickness defining a ratio in the range of 0.5-20, such as 1-10, preferably 1-3, and each of said probe arms having a specific area or point of contact at its distal end for contacting a specific location among said number of specific locations of said test sample; and
(e) at least one of said probe arms having an extension defining a pointing distal end providing its specific area or point of contact located offset relative to its perpendicular bisector;
(f) said multi-point probe communicating with said electric properties testing means; and

(iv) reciprocating means for moving said multi-point probe relative said test sample so as to cause said conductive probe arms to be contacted with said specific location of said test sample for performing said testing of electric properties thereof.

The multi-point testing apparatus according to the second aspect of the present invention basically includes a multi-point probe according to the first aspect of the present invention, which multi-point probe, constituting a component of the multi-point testing apparatus according to second aspect of the present invention, may be implemented in accordance with any of the above features of the multi-point probe according to the first aspect of the present invention. Furthermore, the multi-point testing apparatus according to the second aspect of the present invention includes electric properties testing means for testing the test sample comprising an electric generator means providing a test signal to the surface of the test sample, that being current or voltage, pulsed signal or signals, DC or AC having sinusoidal, squared, triangled signal contents or combinations thereof, ranging from LF to RF including HF, in accordance with specific requirements such as measurements of resistance, inductance, capacitance, slew rate, unity gain bandwidth and 3dB bandwidth. The electric properties testing means further comprises an electric measuring means providing facilities for detecting a measuring signal of the above described test signal types and frequency ranges, and providing extensive electric properties testing information and including functionalities as Fast Fourier Transformation (FFT), phase lock and real time visualisation of measured test signal. The electric properties testing means features probing means for probing of the test sample, in accordance with specific requirements, so as to perform the link between the surface of the test sample and the electric properties testing means.

The multi-point testing apparatus according to the second aspect of the present invention also includes a back-gate for connecting the electric properties testing means to the test sample. The back-gate is especially suitable for being used in conjunction with a multi-point probe having three conductive probe arms for testing electrical properties of a test sample.

The multi-point testing apparatus according to the second aspect of the present invention also includes reciprocating means for holding a multi-point probe according to the first aspect of the present invention, and positioning of the multi-point probe according to the first aspect of the present invention relative to the test sample so as to cause the conductive probe arms to obtain physical contact with a specific location on the surface of the test sample for performing the testing of the electric properties, and for recording of the specific location of the multi-point probe according to the first aspect of the present invention relative to the test sample, having a resolution of 0.1 1$\mu$m or even smaller in all spatial directions. An object of having full manoeuvrability in all spatial directions, that being co-planar to the surface of the test sample or perpendicular to the surface of the test sample, is to allow for multiple point measurements utilising one calibrated multi-point probe according to the first aspect of the present invention on a full surface of a test sample, hence avoiding inaccuracies due to a multiple of calibration discrepancies. The manoeuvrability includes angular movements along an axis parallel to surface of the test sample, providing an angle between the surface of the test sample and the length of the conductive probe arms on the multi-point probe according to the first aspect of the invention, thus utilising the flexibility of the conductive probe arms to insure against possible destruction or deterioration of devices on the surface of the test sample, and along an axis perpendicular to the surface of the test sample providing a 360° rotation of the multi-point probe according to the first aspect of the present invention enabling measurements on devices on the surface of the test sample having any mutual relative co-planar angular positions.

The multi-point testing apparatus according to the second aspect of the present invention further includes means for sensing physical contact between the surface of the test sample and the multiple of conductive probe arms of the multi-point probe according to the first aspect of the present invention insuring non-destructive testing of the test sample and hence avoiding the destruction of possible devices on the surface of the test sample.

The above object, the above advantage and the above feature, together with numerous other objects, advantages and features which will be evident from the below detailed description of a presently preferred embodiment of the present invention, are obtained by a third aspect of the present invention, by a method of producing a multi-point probe comprising the following steps:

(i) producing a wafer body;
(ii) producing a first multiple of conductive probe arms positioned in co-planar and facial relationship with said wafer body; and
(iii) removing a part of said wafer body for providing said conductive probe arms freely extending from said non-removed part of said wafer body constituting a supporting body from which said conductive probe arms extend freely.

The method of producing the multi-point probe in accordance with a third aspect of the present invention may involve any relevant production technique allowing the production of the freely extending conductive probe arms extending freely in relation to the supporting body. Techniques of relevance and interest are based on semiconductor micro-fabrication technology, thick-film technique, thin-film technique or combinations thereof. The method of producing may further involve any relevant production technique for producing conductive probe arms that are multilayered. The relevant production technique may further be a process of chemical vapour deposition (CVD), plasma enhanced CVD (PECVD), electron cyclotron resonance (ECR) or sputtering, mechanical grinding, etching, high resolution lithographic methods such as UV lithography , electron-beam lithography, atomic force microscopy (AFM) lithography, focused ion beam (FIB), or laser lithography.

## Brief description of the drawings

Additional objects and features of the present invention will be more readily apparent from the following detailed description and appended claims with taken in conjunction with the drawing, in which:

Figure 1, provides an overall illustration of the conventional four-point probe measurement on a test sample;

Figure 2, provides an overall illustration of a measurement on a test sample using an asymmetrical four-point probe;

Figure 3, provides a schematic illustration of the flexing and twisting of a probe arm without an aperture; where the two electrodes move towards each other when engaged on a surface.

Figure 4, provides a schematic illustration of the flexing and twisting of a probe arm with an aperture;

Figure 5, provides an illustration of a profile of an asymmetric four-point probe measurement according to a preferred embodiment;

Figure 6, depicts the substrate after patterning a deposited support layer;

Figure 7, illustrates the formation of the probe arms by removal of part of the substrate;

Figure 8, depicts the etching of the substrate to undercut the probe arms;

Figure 9, depicts the deposition of an electrically conducting layer.

**Detailed description of the invention**

The general technique of a multi-point probe, and the method of using a multi-point probe for testing electric properties on a specific location of a test sample, is described in detailed in EP1095282B1. There are similarities between the subject matter of this publication and the present invention, and all the described techniques and methods may also be employed here.

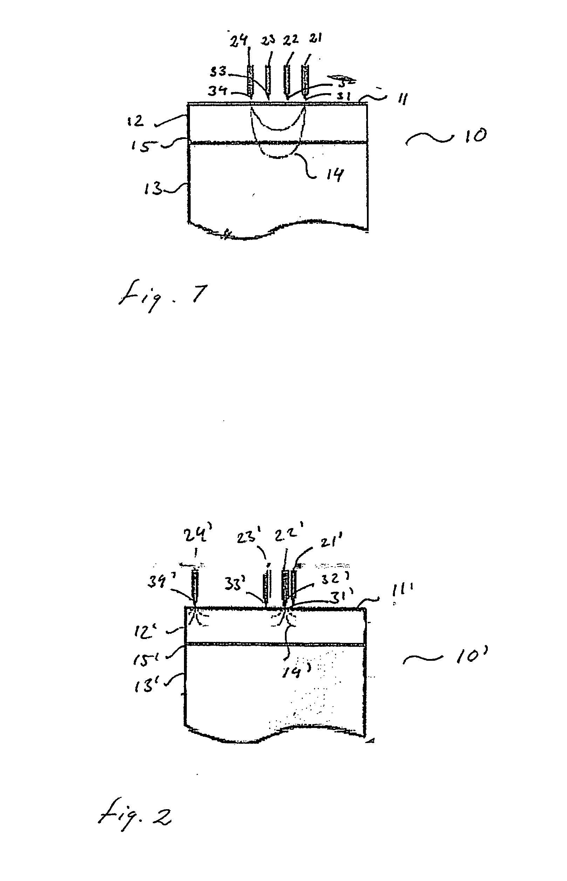

Figure 1 provides an overall illustration of the conventional four-point probe measurement technique on a test sample 10, where the probe arms 21, 22, 23 and 24 have their specific areas or points of contact in an in-line configuration. In this example the test sample is a bi-layer material comprising two layers with different properties. The sample top layer 12 is attached to the sample bottom layer 13 via a merging surface 15. The probe arms 21 and 24 supply a current through the specific areas or points of contact 31 and 34 of the two probe arms. The current is represented by current lines 14 going from the test sample surface 11 into the test sample 10. The other two probe arms 22 and 23 are employed to measure the voltage between the corresponding specific areas or points of contact 32 and 33 of the probe arms.

In this specific example, $a$ is the separation between 31 and 32, $b$ is the separation between 31 and 33, $c$ is the separation between 32 and 34, and $d$ is the separation between 33 and 34. If $\rho c$ is the specific contact resistance ( or contact resistivity or resistance area product) in the unit $\Omega m^2$ of the merging surface 15, $R_T$ and $R_B$ are the resistances or sheet resistances of the sample top layer 12 and sample bottom layer 13, respectively; the measured voltage $V$ between the specific areas or points of contact 32 and 33 at a current $I$, which is induced by the probe arms 21 and 24, can be modelled and described by the following relation:

$$\frac{V}{I} = \frac{R_T R_B}{R_T + R_B} \frac{1}{2\pi} \left( \frac{R_T}{R_B} \left( K_0\left(\frac{a}{\lambda}\right) + K_0\left(\frac{d}{\lambda}\right) - K_0\left(\frac{b}{\lambda}\right) - K_0\left(\frac{c}{\lambda}\right) \right) + \ln\left(\frac{bc}{ad}\right) \right), \qquad (1)$$

where $K_0(x)$ is the modified Bessel of the second kind of order zero, a function which decreases rapidly with an increasing arbitrary variable $x$, and $\lambda$ is the transfer length given by:

$$\lambda = \left( \frac{\rho_C}{R_T + R_B} \right)^{1/2}. \qquad (2)$$

In order to increase the surface sensitivity and the spatial resolution in the multi-point probe measurements, and simultaneously avoiding the negative scaling effects, a different approach than the above described down-scaling is necessary. One such approach is to change the probe arm configuration from equidistant to asymmetric, as is shown in the generalized illustration in Figure 2. When a current flow is injected by a specific area or point of contact 32' of a probe arm 22', the electrostatic potential in close proximity to the current injection point mainly depends on the conductivity of the sample top layer 12'.

The asymmetric probe arm configuration has the advantage, that the minimum electrode probe-arm distance is only necessary between two of the four probe arms, i.e. probe arms 21' and 22' in the generalized illustration in Figure 2. Thus the probe arm configuration is more flexible for minimizing scaling effects discussed above, especially if it is used in conjunction with asymmetrical or non-unidirectional probe arms. Any of the probe arms 21'-23' can be used for current injection and voltage measurement, and the fourth probe arm 24' can principally be place anywhere on a test sample as a back-gate.

The specific example of related art given above in relation to Equations 1 and 2 can be adjusted according to the suggested asymmetric probe arm configuration. By the definition of the separations given above, if the probe arm 34 in Figure 1 is placed at a greater distance from the other three probe arms, both of the separations c and d will increase. For a sufficiently large separations c and d, equation 1 above can be approximated by:

$$\frac{V_{Asym}}{I} = \frac{R_T R_B}{R_T + R_B} \frac{1}{2\pi} \left( \frac{R_T}{R_B} \left( K_0 \left( \frac{a}{\lambda} \right) - K_0 \left( \frac{b}{\lambda} \right) \right) + \ln \left( \frac{b}{a} \right) \right), \tag{3}$$

Clearly, the voltage $V_{Asym}$ between the specific areas or points of contact 32 an 33 and the injected current $I$ through the probe arm 21 can readily be employed for deriving electrical properties of a bi-layered ( or multi-layered) test sample, when using an asymmetric probe arm configuration.

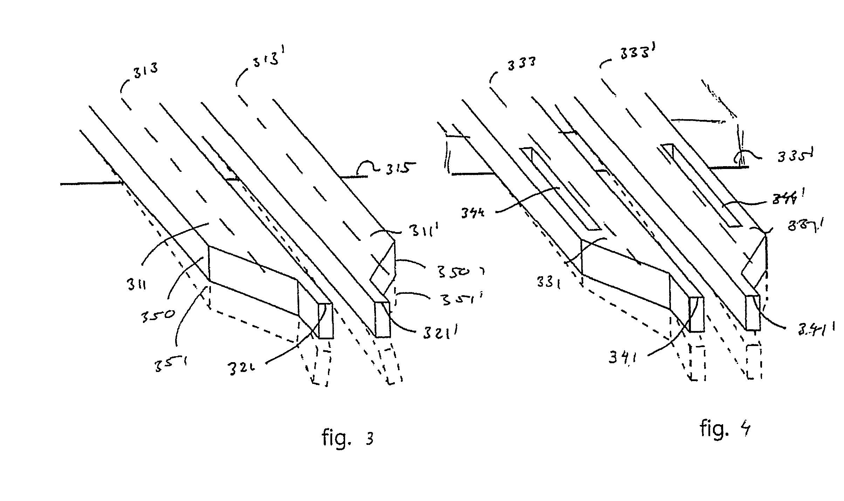

The concept of an elongated through-going aperture extending in the lengthwise direction of a probe arm is revealed in the different aspects of the present invention. Figures 3-4 are included to schematically illustrate the workings of an aperture when a probe arm is employed in a measurement. It is understood that the twisting of the probe arms in Figure 3 is exaggerated, which is done to demonstrate the desired technical effect.

Figure 3 shows two probe arms 311 attached onto a supporting body 315, where the solid profiles 350 corresponds to a situation of non-employed probe arms, while the dashed profiles 351 corresponds to a situation of probe arms actively employed in a measurement. The probe arms 311 have points of contacts 321, which are offset relative to the perpendicular bisectors 313. An orthonormal basis of the vectors $e_x$, $e_y$ and $e_z$, can be defined in Figure 3, where $e_x$ is parallel to the perpendicular bisectors 313 and $e_y$ is parallel to a line between the points of contacts 321. The actively employed probe arms are affected by a driving force component in a direction parallel to $e_z$, which essentially results in two types of moments, a flexing and a twisting moment. The flexing moments are induced by the offset between the point of contacts 321 and the supporting body 315, while the twisting moments are induced by the offset between point of contacts 321 and the perpendicular bisectors 313. The points of contact 321 are located closer to one another than the perpendicular bisectors 313, resulting in opposite signs of the two twisting moments when the probe arms are actively employed. Consequently, the twisting moments deforms the probe arms 311 so that the points of contact 321 are brought closer to one another than when the probe arms 311 are non-employed, representing opposite lateral movements of the points of contact 321.

In Figure 4 each of the probe arms 331 has an elongated through-going aperture 344 extending lengthwise, i.e. parallel to the perpendicular bisectors 333. In all other aspects, the probe arms 331 and the supporting body 335 are identical to the corresponding elements 313 and 315 illustrated in Figure 3. The aperture 344 of each probe arm is positioned on the opposite side of the perpendicular bisector 333 from the point of contact 341. The apertures 344 will change the structural properties of the probe arms 331 so that, when the probe arms 331 are employed, the lateral movement of the point of contact 321 of each probe arm 331 is substantially eliminated, even though the twisting moments are still present.

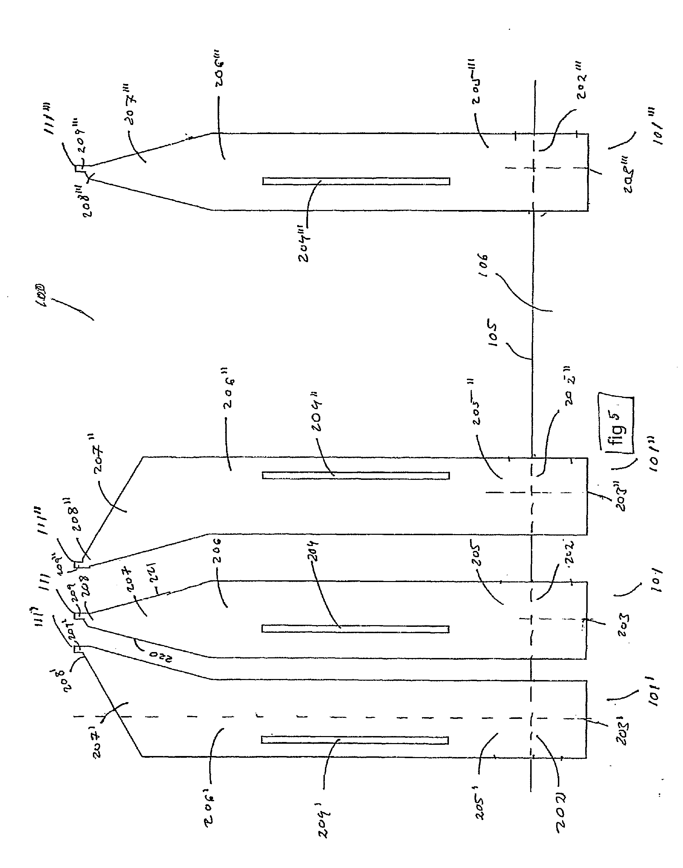

A preferred embodiment of a four-point probe is described with reference to Figure 5. Although this particular embodiment encompasses only four probe arms, it is understood that the some, or all, of the advantages and features of this embodiment also can be applied to any multi-point probe with an unspecified number of probe arms.

The profile of a four-point probe 100 having four probe arms 101-101''' placed in a sequence is shown in Figure 5. The probe arms 101-101''' are connected to a planar supporting body 105 at their proximal ends 205-205''' by the lines of contact 202-202'''. Each of the lines of contact 202-202''' defines a perpendicular bisector 203-203''' extending lengthwise along the corresponding probe arm 101-101''' in a plane parallel to the plane 106 defined by the supporting body 105. Each of the probe arms 101-101''' has a tapered element 207-207''' and a specific area or point of contact 111-111''' at the distal ends 206-206''', where the specific areas or points of contact 111-111''' are located on a line being parallel to the lines of contact 202-202'''.

In this particular preferred embodiment, the specific areas or points of contact 111-111''' are located on pointed shaped elements 209-209''' at the narrowest portion 208-208''' of the tapered element 207-207'''. Further, the first 101' and the third 101" probe arms have the tapered element 207' and 207" at an angle relative to their perpendicular bisectors 203' and 203", i.e. the narrowest portions 208' and 208" are offset relative to the perpendicular bisectors 203' and 203"; and the tapered elements 207' and 207" are oriented so that the specific areas or points of contact 111' and 111" are located closer to one another than the bisectors 203' and 203" of the probe arms 101' and 101" they belong to.

The second 101 and the fourth 101''' probe arms have tapered elements 207 and 207''' without any angle to the perpendicular bisectors 203 and 203'''0, i.e. the narrowest portions 208 and 208''' are aligned along the perpendicular bisectors 203 and 203'''. However, the pointed shaped elements 209 and 209''' are located offset relative to the perpendicular bisectors 203 and 203''' of the probe arms 101 and 101'''. Hence, all of the specific areas or points of contact 111-111''' are located offset relative to the respective perpendicular bisectors 203-203''', the first 101' and third 101" probe arms by a larger amount than the second 101 and fourth 101 '''. This will cause the specific areas or points of contact 111-111''' to move in a lateral directions perpendicular to the perpendicular bisectors 203-203''', when flexibly moving the specific areas or points of contact 111-111''' parallel to the normal of the plane 106 of the supporting body 105, e.g. when the probe 100 is employed in a measurement, as is further explained in relation to Figures 3 and 4. The lateral movement is, to any substantial extent, eliminated by elongated and through-going apertures 204-204''', which extend lengthwise and offset relative to the perpendicular bisectors 203-203'''. The aperture 204-204''' of each probe arms 101-101''' is located on the opposite side of the perpendicular bisector 203-203''' from the corresponding specific area or point of contact 111-111'''.

The features of the four-point probe 100 will allow for high sensitivity measurements, with the shortest distances between the specific areas or points of contact below $1\mu$, and will simultaneously circumvent the earlier mentioned critical scaling effects. The distance between the specific areas or points of contact first 101' and second 101 probe arms is smaller than, but of the same order of magnitude, as the corresponding distance between the second 101 and the third 101" probe arm. In an alternative embodiment, these two distances may be substantially the same. The distance between the specific areas or points of contact of the third 101" and fourth 101" probe arms is, however, about an order of magnitude larger than the first two distances.

In operation an external positioning device places a multi-point probe made according to the present invention into physical contact with the surface of the test sample. Once electrical contact between the surface of the test sample and all four conductive probe arms has been achieved, a current is applied to two of the conductive probe arms and a corresponding voltage is measured between the two other conductive arms. The method for applying the current and detecting the voltage can be any method known in the art. In an alternative embodiment, the fourth probe arm 101''' is replaced with a back-gate (not shown in Figure 5). A back-gate can in principle be placed anywhere on the surface of a test sample, and will substitute one of the probe arms.

In a preferred embodiment, the first probe arm 101' has an extension or tapered element 207' that defines a pointing distal end or narrowest portion 208' providing its specific area or point of contact 111', which is located offset relative to its perpendicular bisector 203'. The second probe arm 101 is located juxtaposed to the first probe arm 101' and has at its distal end 206 a bevelled end face 220 congruent with the extension 207' of the first probe arm 101'. The bevelled end face 220 defines a pointing distal or narrowest portion 208', which constitutes its specific area or point of contact 111 located closely spaced from the specific area or point of contact 111' of the first probe arm 101'.

The second probe arm 101 also has another bevelled end face 221 located on the other side of the perpendicular bisector 203 of the second probe arm 101 with respect to the first probe arm 101', where the other bevelled end face 207 is congruent with the extension or tapered element 207" of the third probe arm 101". The specific areas or point of contact 111-11" of the three first probe arms 101-101" are all located closely spaced from one another in that the beveled surfaces 220 and 221 allows for a closer spacing by way of the extensions 207' and 207". Further, the second probe arm 101 also has its specific area or point of contact 111 located offset relative to its perpendicular bisector 203 on the side of which the third probe arm 101" is located.

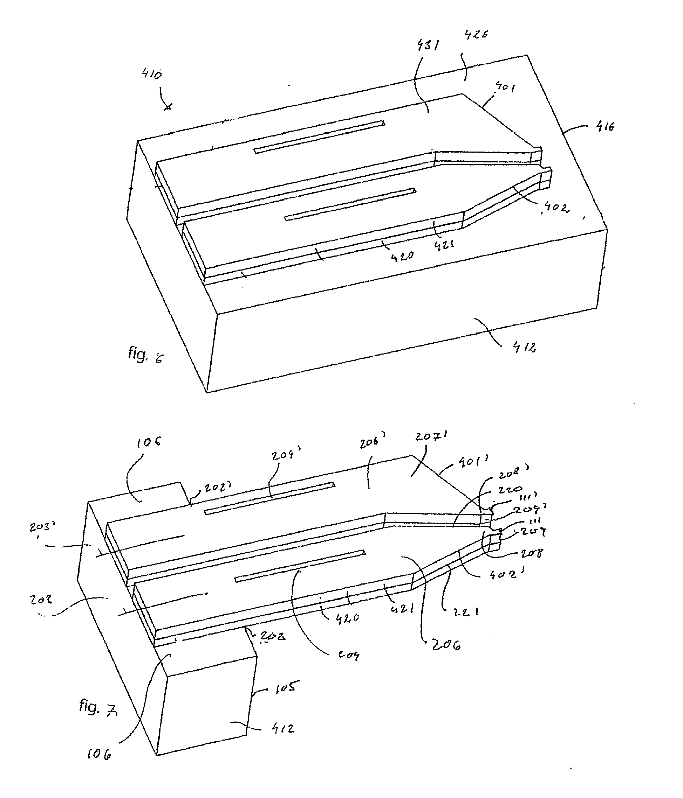

A preferred embodiment is directed toward making a multi-point probe and is described with respect to Figures 6-9. Although only two probe arms are featured in the preferred embodiment, it is understood that described methods can be employed for manufacturing multi-point probes having an arbitrary number of probe arms.

Figure 6 shows a wafer 410, for example a section of a semiconductor wafer, in intermediate state of fabrication. It shows a surface 416 of a substrate 412 covered by a bottom layer 420, being either electrically isolating or semi-conducting. The bottom layer 420 is in turn covered by a carrying layer 421, also being either electrically isolating or semi-conducting. In a preferred embodiment the bottom layer is of silicon dioxide, and the carrying layer is of poly-crystalline silicon. The deposition of the bottom layer 420 and subsequently the carrying layer 421 can be accomplished by any technique known in the art, such as chemical vapour deposition (CVD), plasma enhanced CVD (PECVD), low-pressure CVD (LPCVD), electron cyclotron resonance (ECR) or sputtering. In an alternative embodiment the carrying layer 421 is of poly-crystalline silicon created by laser-crystallisation of amorphous silicon, which has been deposited onto the bottom layer 420 by the previously mentioned techniques, e.g. PECVD. Alternatively, in another preferred embodiment the substrate 412 and the bottom layer 420 is a silicon-on-insulator (SOI) wafer, with mono-crystalline silicon as the material of the carrying layer 421.

As shown in Figure 3, the bottom layer 420 and carrying layer 421 are patterned and etched to form the beams 401 and 402, having the features and characteristics of the probe arms 101 and 102 in Figure 5, respectively. The beams are not limited to any particular form or symmetry; they can be of any geometry defining suitable specific areas or points of contact.

The pattern is formed by forming a photoresist pattern (not shown in Figure 6) which defines the two beams 401 and 402 on the top surface 431 of the carrying layer 421. The photoresist pattern is formed by conventional photolithographic photoresist formation, exposure, development and removal techniques. The bottom layer 420 and the carrying layer 421 are then etched using any technique known in the art, such as dry etching, wet etching, reactive ion etching (RIE), and advanced silicon etching (ASE), until the unmasked parts of the carrying layer 421 and bottom layer 420 are removed from the top surface 426 of the substrate 412. The etching may be performed in several steps using the one or several etching techniques.

In an alternative embodiment of the present invention the two beams 401 and 402, or parts of them, can be defined using high-resolution lithographic methods such as electron-beam lithography, focused ion-beam lithography, atomic-force microscopy (AFM) lithography, laser lithography, UV-lithography, or a combination thereof. As an example to a particular alternative embodiment of this kind, the focused ion-beam lithography may be employed to define the smallest features or structures of the multi-point probe, while other high-resolution lithographic methods are employed for the larger features or structures.

Once the bottom layer 420 has been patterned, the substrate is partially removed to release the patterned bottom layer 420, forming two probe arms 401' and 402', as is illustrated in Figure 7. The probe arms 401' and 402' have the same features and characteristics as the probe arms 101 and 102 in Figure 5, respectively.

In the preferred embodiment, the substrate is removed as illustrated in Figure 7. The removal is achieved by depositing a protective layer (not shown in Figure 7) of silicon nitride on the top and bottom surfaces of the substrate 412. Next, a photoresist pattern is formed on the bottom surface of the substrate by conventional photolithographic photoresist formation, exposure, development and removal techniques. The nitride layer is then removed in the unmasked areas on the bottom surface of the substrate using reactive ion etch (RIE), e.g. in a plasma containing $SF_6$ and $O_2$ or similar reagents, and the substrate is etched using an etching chemistry comprising potassium hydroxide (KOH) or a similar chemistry until the freely extending probe arms 401' and 402' are exposed. Alternatively, in another preferred embodiment deep reactive ion etching (DRIE) or ASE is used instead of KOH. The protecting layer of nitride is removed from the top surface of the substrate using RIE, or using wet etching with a chemistry comprising phosphoric acid ($H_3PO_4$), or a similar chemistry.

Some of the essential features of a preferred embodiment of a multi-point probe can be found in Figure 7. The first probe arm 401' has an extension 207' defining a pointing end 208' and providing its specific area or point of contact 111' located offset relative to its perpendicular bisector 203'. The second probe arm 402' is located juxtaposed the first probe arm 401' and has at its distal end 206 a bevelled end face 220 congruent with the extension 207' of the first probe arm 401'. The bevelled end face 220 defines a pointing distal end 208 constituting its specific area or point of contact 111 located closely spaced from the specific area or point of contact 111' of the first probe arm. Further, the specific area or point of contact 111 of the second probe arm 102 is also located offset relative to its perpendicular bisector 203. Figure 7 also shows an endpoint of the line of contact 202'of the first probe arm 401', and an endpoint of the line of contact 202 of the first probe arm 401'. The second probe arm 402' also has another bevelled end face 221 located on the opposite side of the perpendicular bisector 203 from the first probe arm 401'. Further, the probe arms 401' and 402' have elongated through-going apertures 204' and 204 extending lengthwise and offset relative to the perpendicular bisectors 203' and 203. This embodiment may eliminate, to any substantial extent, any motion perpendicular to the perpendicular bisectors 203' and 203 and parallel to the first surface 106 when flexibly moving them relative to the supporting body 105 and moving the specific areas or points of contact 111' and 111 perpendicularly to the first surface 106.

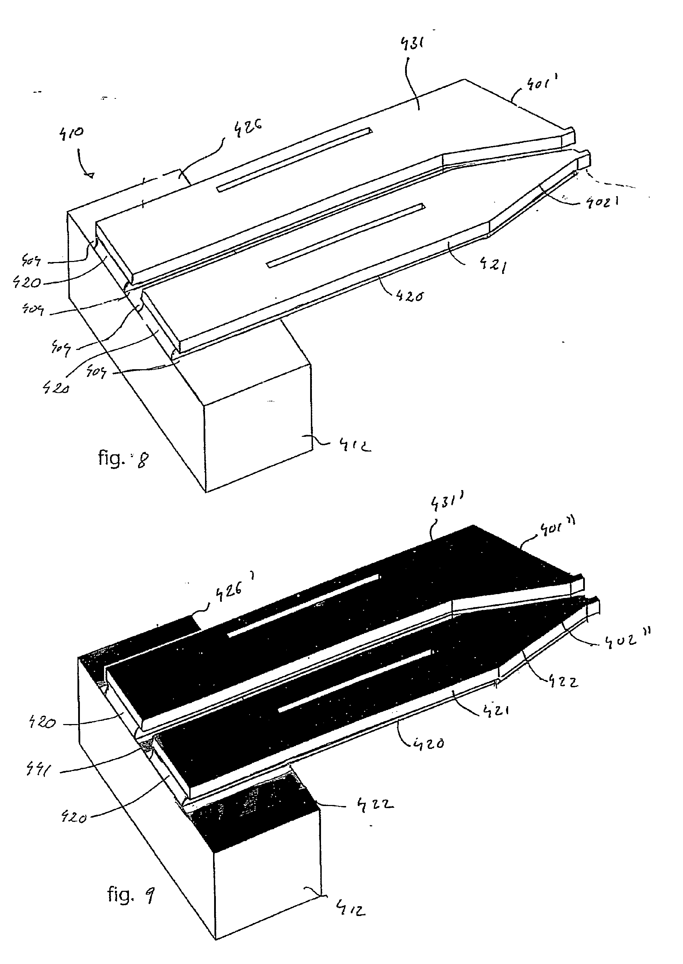

Figure 8 illustrates the etching of the bottom layer to undercut the carrying layer 421. In this preferred embodiment, the etching step is performed with a dry etching method, such as an isotropic RIE etch. Alternatively, in the undercut may be achieved by buffered oxide etching (bHF or HF) or advanced oxide etching (AOE). Further, after the etching the pointed shaped elements 209 and 209' may no longer be supported by the bottom layer 420, but only the carrying layer 421. Although not shown in Figure 8, an undercut of the bottom layer 420 may also be obtained by etching of the substrate 412 using similar techniques or chemistries.

The final stage of fabrication is shown in Figure 9, and involves the deposition of an electrically conducting layer 422 on the top surface of the wafer 410. The conducting layer 422 is made of conducting materials like Au, Ag, Pt, Ni, Ta, Ti, Cr, Cu, Os, W, Mo, Ir, Pd, Cd, Re, conductive diamond, metal silicides, conducting ceramic, or combinations thereof. Alternatively, the conducting layer can be made of a highly doped semiconducting material. The conducting layer 422 can be deposited using electron-beam evaporation, or any other similar technique known in the art. Due to the undercutting of the bottom layer 420, the electrically conducting layer 422 will not create conducting paths between the two probe arms, and two electrically isolated but conducting probe arms 401" and 402" are formed. The specific areas or points of contact of the probe arms 401" and 402" can now be electrically connected to an external positioning and measuring device (not shown in Figure 9).

As shown in Figure 9, the deposition of the conducting layer creates electrodes on the substrate. In a preferred embodiment these electrodes are used for active guarding of the conductive probe arms to significantly reduce leakage resistance and, consequently, increase the measuring accuracy of the invention.

A set of points characterizing the invention:

1. A multi-point probe for testing electrical properties of a number of specific locations of a test sample, said multi-point probe comprising:

(a) a supporting body defining a first surface;

(b) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;

(c) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;

(d) each of said probe arms defining a maximum width perpendicular to its perpendicular bisector and parallel with its line of contact with said supporting body, and a maximum thickness perpendicular to its perpendicular bisector and its line of contact with said supporting body, said maximum width and said maximum thickness defining a ratio in the range of 0.5-20, such as 1-10, preferably 1-3, and each of said probe arms having a specific area or point of contact at its distal end for contacting a specific location among said number of specific locations of said test sample; and

(e) at least one of said probe arms having an extension defining a pointing distal end providing its specific area or point of contact located offset relative to its perpendicular bisector.

2. The multi-point probe according to point 1, wherein another of said probe arms located juxtaposed said one probe arm and having at its distal end a bevelled end face congruent with said extension of said one probe arm and defining a pointing distal end constituting its specific area or point of contact located closely spaced from said specific area or point of contact of said one probe arm.

3. The multi-point probe according to point 2, wherein said specific area or point of contact of said other probe arm is located offset relative to its perpendicular bisector.

4. The multi-point probe according to points 1-3, wherein at least one of said probe arms further having an elongated through-going aperture extending lengthwise and offset relative to its perpendicular bisector of said at least one probe arm for eliminating, to any substantial extent, any motion perpendicular to its perpendicular bisector and parallel to said first surface when flexibly moving it relative to said supporting body and moving said specific area or point of contact perpendicular to said first surface.

5. The multi-point probe according to any of the points 1-4, wherein said first multitude of conductive probe arms are unidirectional.

6. The multi-point probe according to any of the points 1-5, wherein a first distance is defined between said specific area or point of contact of a first probe arm of said conductive probe arms to said specific area or point of contact of a second probe arm of said conductive probe arms, a second distance is defined between said normal bisector of said first probe arm to said normal bisector of said second probe arm, together defining a pair of distances, and said first distance is smaller than said second distance.

7. The multi-point probe according to points 1-6, wherein three of said conductive probe arms are placed in a sequence on said supporting body and are separated by a first separation corresponding said pair of distances and a second separation also corresponding to said pair of distances, where said first distance is smaller than said second distance in each of said first separation and said second separation.

8. The multi-point probe according to points 1-7, wherein said first distance of said first separation is substantially the same as said first distance of said second separation.

9. The multi-point probe according to points 1-8, where said first distance of said first separation is substantially different from said first distance of said second separation.

10. The multi-point probe according to points 1-9, where said first distance of said first separation is in the ranges 1 nm to 120$\mu$m, 40nm to 60$\mu$m, 80nm to 30$\mu$m, and/or 160nm to 15$\mu$m, preferably 200nm, and said first distance of said second separation is in the ranges 1 nm to 120$\mu$m, 40nm to 60$\mu$m, 80nm to 30$\mu$m, and/or 160nm to 15$\mu$m, preferably 200nm.

11. The multi-point probe according to points 1-10, where said first distance of said first separation is in the range 1 nm to 100nm, 100nm to 300nm, 300nm to 1$\mu$m, 1$\mu$m to 5$\mu$m, 5$\mu$m to 20$\mu$m, or 20$\mu$m to 120$\mu$m, and said first distance of said second separation is in the range 1 nm to 100nm, 100nm to 300nm, 300nm to 1$\mu$m, 1$\mu$m to 5$\mu$m, 5$\mu$m to 20$\mu$m, or 20$\mu$m to 120$\mu$m.

12. The multi-point probe according to points 7-11, wherein another of said conductive probe arms is located in sequence with said sequence of three conductive probe arms and separated from the closest of said three conductive probe arms by a third separation corresponding to said pair of distances, said third separation having a first distance which is larger than both said first distance of said first separation and said first distance of said second separation.

13. The multi-point probe according to point 12, wherein said third separation has a first distance which is larger than either of said first distance of said first separation and said first distance of said second separation by factor in the ranges 2 to 1000, 5 to 800, 10 to 600, and/or 20 to 400, preferably 40.

14. The multi-point probe according to points 12 and 13, wherein said third separation has a first distance which is larger than either of said first distance of said first separation and said first distance of said second separation by factor in the ranges 3 to 10, 10 to 30, 30 to 90, 90 to 300, 300 to 1000, $10^3$ to $10^4$, $10^4$ to $10^5$, $10^5$ to $10^6$, $10^6$ to $10^7$, or $10^7$ to $10^8$.

15. The multi-point probe according to points 1-14, wherein said first multitude of conductive probe arms are multilayered and define a top layer and a bottom layer for each of said probe arms, said bottom layer is connected to said supporting body, while said top layer is connected to said bottom layer and is located on the opposite side of said bottom layer from said supporting body, and, if disregarding all elongated through-going apertures, each of said top layer and said bottom layer has a substantially rectangular cross section defining: the dimension of width as a distance between the lines of said rectangular cross section perpendicular to the plane of said first surface of said supporting body, the dimension of depth as a distance between the lines of said rectangular cross section parallel to the plane of said first surface of supporting body, and the dimension of length as a distance from said proximal end of said conductive probe arms to said distal end of said conductive probe arm.

16. The multi-point probe according to point 15, wherein each of said conductive probe arms has a depth of said top layer that is smaller than or substantially equal to the depth of said bottom layer.

17. The multi-point probe according to points 15 and 16, wherein each of said conductive probe arms has a width of said top layer that is larger than or substantially equal to the width of said bottom layer.

18. The multi-point probe according to points 1-17, wherein said first multitude of conductive probe arms have a ratio of said length to said width of said bottom layer within the range of 500:1 to 2:1, such as ratios 50:1 and 5:1, preferable application having the ratio of 5:1.

19. The multi-point probe according to points 1-18, wherein said first multitude of conductive probe arms have a ratio of said width to said depth of said bottom layer within the range of 20:1 to 1:5, preferable application having the ratio of 2:1.

20. The multi-point probe according to points 1-19, wherein at least one of said conductive probe arms has tapered elements extending from said distal end of said conductive probe arms.

21. The multi-point probe according to points 1-20, wherein at least one of said conductive probe arms has a tapered element extending from said distal end of said conductive probe arm, said tapered element being multilayered and define a tapered top layer and a tapered bottom layer, which are extensions of said top layer and said bottom layer, respectively, of said conductive probe arm; and said specific area or point of contact is located at said tapered element.

22. The multi-point probe according to points 1-21, wherein at least one of said conductive probe arms has a pointed shaped element extending from an area, point or tapered element at said distal end of said conductive probe arms, and said specific area or point of contact is located on said pointed shaped element.

23. The multi-point probe according to points 1-22, wherein said first multitude of conductive probe arms have said lengths in the range of 100 nm to 2mm, preferably a length of 10 $\mu$m.

24. The multi-point probe according to points 1-23, wherein supporting body is of a ceramic material.

25. The multi-point probe according to points 1-23, wherein supporting body is of a semiconducting material.

26. The multi-point probe according to point 25, wherein said semiconducting material comprising Ge, Si or any combinations thereof.

27. The multi-point probe according to points 1-26, wherein said bottom layer is a dielectric material or a semiconductor.

28. The multi-point probe according to point 27, wherein said dielectric material or a semiconductor comprises $SiO_2$.

29. The multi-point probe according to points 1-28, wherein said top layer is a conducting layer.

30. The multi-point probe according to points 1-28, wherein said top layer comprises: a conducting layer and a carrying layer, said carrying layer being in contact with said bottom layer, while said conducting layer is connected to said carrying layer and is located on the opposite side of said carrying layer from said bottom layer.

31. The multi-point probe according to points 29 and 30, wherein said conducting layer comprising conductive materials, such as Au, Ag, Pt, Ni, Ta, Ti, Cr, Cu, Os, W, Mo, Ir, Pd, Cd, Re, conductive diamond, metal silicides, conducing ceramic, or any combinations thereof.

32. The multi-point probe according to points 30 and 31, wherein said carrying layer comprises semiconducting materials, such as crystalline or poly-crystalline silicon, dielectric materials, metals, or alloys.

33. A multi-point testing apparatus for testing electric properties on a specific location of a test sample, comprising:

(i) means for receiving and supporting said test sample;
(ii) electric properties testing means including electric generator means for generating a test signal and electric measuring means for detecting a measuring signal;
(iii) a multi-point probe, comprising:

(a) a supporting body defining a first surface;
(b) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;
(c) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
(d) each of said probe arms defining a maximum width perpendicular to its perpendicular bisector and parallel with its line of contact with said supporting body, and a maximum thickness perpendicular to its perpendicular bisector and its line of contact with said supporting body, said maximum width and said maximum thickness defining a ratio in the range of 0.5-20, such as 1-10, preferably 1-3, and each of said probe arms having a specific area or point of contact at its distal end for contacting a specific location among said number of specific locations of said test sample; and

(e) at least one of said probe arms having an extension defining a pointing distal end providing its specific area or point of contact located offset relative to its perpendicular bisector;

(f) said multi-point probe communicating with said electric properties testing means; and

(iv) reciprocating means for moving said multi-point probe relative said test sample so as to cause said conductive probe arms to be contacted with said specific location of said test sample for performing said testing of electric properties thereof.

34. The multi-point testing apparatus according to point 33, wherein said multi-point testing apparatus further comprises a back-gate for connecting said electric properties testing means to said test sample, said back-gate being especially suitable for being used in conjunction with a multi-point probe having at least three conductive probe arms for testing electrical properties of a test sample.

35. The multi-point testing apparatus according to points 33 and 34, wherein said electric properties testing means further comprising means for electric properties probing of said test sample.

36. The multi-point testing apparatus according to points 33-35, wherein said reciprocating means further comprises holding means for said means for said multi-point probe.

37. The multi-point testing apparatus according to points 33-36, further comprising means for positioning said holding means across said test sample and recording of a location of said holding means relative to said test sample.

38. The multi-point testing apparatus according to points 33-37, wherein said means for positioning comprising manoeuvrability in all spatial directions, being directions co-planar to said test sample and directions perpendicular to said test sample.

39. The multi-point testing apparatus according to points 33-38, wherein said means for positioning further comprising means for angular movement of said holding means, such as to provide angular positions for said means for said multi-point probe.

40. The multi-point testing apparatus according to points 33-39, wherein said means for positioning further comprising means for angular movement of said holding means along an axis parallel to surface of said test sample, such as to provide angular positions for said means for said multi-point probe.

41. The multi-point testing apparatus according to points 33-40, wherein said means for positioning further comprising means for angular movement of said holding means along an axis perpendicular to surface of said test sample, such as to provide angular positions for said means for said multi-point probe.

42. The multi-point testing apparatus according to points 33-41, wherein said means for positioning further comprising means for sensing contact between said test sample and said means for said multi-point probe.

43. The multi-point testing apparatus according to points 33-42, wherein said multi-point probe further includes any of the features of any of the points 2-32.

44. A method of producing a multi-point probe comprising the following steps:

(i) producing a wafer body;
(ii) producing a first multiple of conductive probe arms positioned in co-planar and facial relationship with said wafer body; and
(iv) removing a part of said wafer body for providing said conductive probe arms freely extending from said non-removed part of said wafer body constituting a supporting body from which said conductive probe arms extend freely.

45. The method of producing a multi-point probe according to point 44, wherein the technique of applying the conductive probe arms in co-planar and facial relationship with the supporting wafer body, involves microfabrication technique, planar technique, CMOS technique, thick-film technique, thin-film technique or a combination thereof.

46. The method of producing a multi-point probe according to points 44 and 45, wherein said first multiple of conductive probe arms are multilayered.

47. The method of producing a multi-point probe according to points 44-46, wherein said first multiple of conductive probe arms are provided by a process of chemical vapour deposition (CVD), plasma enhanced CVD (PECVD), electron cyclotron resonance (ECR) or sputtering, mechanical grinding, etching, high resolution lithographic methods such as UV lithography, electron-beam lithography, atomic force microscopy (AFM) lithography, focused ion beam (FIB) and/or laser lithography.

48. The method according to points 44-47, the multi-point probe having any of the features of the multi-point probe according to any of the points 1-43.

**Claims**

1. A multi-point probe for testing electrical properties of a number of specific locations of a test sample, said multi-point probe comprising:

   (a) a supporting body defining a first surface;
   (b) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;
   (c) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
   (d) each of said probe arms defining a maximum width perpendicular to its perpendicular bisector and parallel with its line of contact with said supporting body, and a maximum thickness perpendicular to its perpendicular bisector and its line of contact with said supporting body, said maximum width and said maximum thickness defining a ratio in the range of 0.5-20, such as 1-10, preferably 1-3, and each of said probe arms having a specific area or point of contact at its distal end for contacting a specific location among said number of specific locations of said test sample; and
   (e) at least one of said probe arms having an extension defining a pointing distal end providing its specific area or point of contact located offset relative to its perpendicular bisector.

2. The multi-point probe according to claim 1, wherein another of said probe arms located juxtaposed said one probe arm and having at its distal end a bevelled end face congruent with said extension of said one probe arm and defining a pointing distal end constituting its specific area or point of contact located closely spaced from said specific area or point of contact of said one probe arm.

3. The multi-point probe according to claim 2, wherein said specific area or point of contact of said other probe arm is located offset relative to its perpendicular bisector.

4. The multi-point probe according to claims 1-3, wherein at least one of said probe arms further having an elongated through-going aperture extending lengthwise and offset relative to its perpendicular bisector of said at least one probe arm for eliminating, to any substantial extent, any motion perpendicular to its perpendicular bisector and parallel to said first surface when flexibly moving it relative to said supporting body and moving said specific area or point of contact perpendicular to said first surface.

5. The multi-point probe according to any of the claims 1-4, wherein said first multitude of conductive probe arms are unidirectional.

6. The multi-point probe according to any of the claims 1-5, wherein a first distance is defined between said specific area or point of contact of a first probe arm of said conductive probe arms to said specific area or point of contact of a second probe arm of said conductive probe arms, a second distance is defined between said normal bisector of said first probe arm to said normal bisector of said second probe arm, together defining a pair of distances, and said first distance is smaller than said second distance.

7. The multi-point probe according to claims 1-6, wherein three of said conductive probe arms are placed in a sequence on said supporting body and are separated by a first separation corresponding said pair of distances and a second separation also corresponding to said pair of distances, where said first distance is smaller than said second distance in each of said first separation and said second separation.

8. The multi-point probe according to claim 7, wherein another of said conductive probe arms is located in sequence with said sequence of three conductive probe arms and separated from the closest of said three conductive probe arms by a third separation corresponding to said pair of distances, said third separation having a first distance which is larger than both said first distance of said first separation and said first distance of said second separation.

9. The multi-point probe according to claims 1-8, wherein said first multitude of conductive probe arms are multilayered and define a top layer and a bottom layer for each of said probe arms, said bottom layer is connected to said supporting body, while said top layer is connected to said bottom layer and is located on the opposite side of said bottom layer from said supporting body, and, if disregarding all elongated through-going apertures, each of said top layer and said bottom layer has a substantially rectangular cross section defining: the dimension of width as a distance between the lines of said rectangular cross section perpendicular to the plane of said first surface of said supporting body, the dimension of depth as a distance between the lines of said rectangular cross section parallel to the plane of said first surface of supporting body, and the dimension of length as a distance from said proximal end of said conductive probe arms to said distal end of said conductive probe arm.

10. A multi-point testing apparatus for testing electric properties on a specific location of a test sample, comprising:

   (i) means for receiving and supporting said test sample;
   (ii) electric properties testing means including electric generator means for generating a test signal and electric measuring means for detecting a measuring signal;
   (iii) a multi-point probe, comprising:

      (g) a supporting body defining a first surface;
      (h) a first multitude of conductive probe arms, each of said probe arms defining a proximal end and a distal end, and said probe arms being connected to said supporting body at said proximal ends, and having said distal ends freely extending from said supporting body, giving individually flexible motion to said probe arms; said probe arms together with said supporting body define lines of contact between each of said probe arms and said supporting body, each of said lines of contact defining a perpendicular bisector being parallel to said first surface;
      (i) said conductive probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
      (j) each of said probe arms defining a maximum width perpendicular to its perpendicular bisector and parallel with its line of contact with said supporting body, and a maximum thickness perpendicular to its perpendicular bisector and its line of contact with said supporting body, said maximum width and said maximum thickness defining a ratio in the range of 0.5-20, such as 1-10, preferably 1-3, and each of said probe arms having a specific area or point of contact at its distal end for contacting a specific location among said number of specific locations of said test sample; and
      (k) at least one of said probe arms having an extension defining a pointing distal end providing its specific area or point of contact located offset relative to its perpendicular bisector;
      (l) said multi-point probe communicating with said electric properties testing means; and

   (iv) reciprocating means for moving said multi-point probe relative said test sample so as to cause said conductive probe arms to be contacted with said specific location of said test sample for performing said testing of electric properties thereof.

11. The multi-point testing apparatus according to claim 10, wherein said multi-point testing apparatus further comprises a back-gate for connecting said electric properties testing means to said test sample, said back-gate being especially suitable for being used in conjunction with a multi-point probe having at least three conductive probe arms for testing electrical properties of a test sample.

12. The multi-point testing apparatus according to claims 10-11, wherein said multi-point probe further includes any of the features of any of the claims 2-9.

13. A method of producing a multi-point probe comprising the following steps:

(i) producing a wafer body;
(ii) producing a first multiple of conductive probe arms positioned in co-planar and facial relationship with said wafer body; and
(iv) removing a part of said wafer body for providing said conductive probe arms freely extending from said non-removed part of said wafer body constituting a supporting body from which said conductive probe arms extend freely.

14. The method of producing a multi-point probe according to claim 13, wherein the technique of applying the conductive probe arms in co-planar and facial relationship with the supporting wafer body, involves microfabrication technique, planar technique, CMOS technique, thick-film technique, thin-film technique or a combination thereof.

15. The method according to claims 13 and 14, the multi-point probe having any of the features of the multi-point probe according to any of the claims 1-12.

fig. 7

fig. 2

EP 2 141 503 A1

fig. 4

fig. 3

20

fig 5

fig. 6

fig. 7

fig. 8

fig. 9

Europäisches
Patentamt

European
Patent Office

Office européen
des brevets

# EUROPEAN SEARCH REPORT

**Application Number**

EP 08 38 8023

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2004/056674 A1 (PETERSEN CHRISTIAN LETH [DK] ET AL) 25 March 2004 (2004-03-25) * figures 1-10,13,14 * * paragraphs [0001], [0010], [0011] * * paragraph [0014] - paragraph [0059] * * paragraph [0092] - paragraph [0109] * * claims 1,50 * | 1-15 | INV. G01R1/073 G01R27/14 |
| X | US 2006/035404 A1 (SAUNDERS J L [US] ET AL SAUNDERS J LYNN [US] ET AL) 16 February 2006 (2006-02-16) * figures 1-7,17-19,23,24C,25A-25D * * paragraph [0001] * * paragraph [0047] - paragraph [0057] * * paragraph [0105] - paragraph [0126] * | 1-15 | |
| X | US 2002/142509 A1 (HATTORI ATSUO [JP] ET AL) 3 October 2002 (2002-10-03) * paragraph [0003]; figures 2A-8B * * paragraph [0053] - paragraph [0078] * | 1-15 | |
| X | US 5 506 515 A (GODSHALK EDWARD M [US] ET AL) 9 April 1996 (1996-04-09) * figures 4-13 * * abstract * | 1,10 | TECHNICAL FIELDS SEARCHED (IPC) G01R |
| A | US 2006/172568 A1 (CHEN CHIH-CHUNG [TW]) 3 August 2006 (2006-08-03) * figures 14-17 * * paragraphs [0002], [0091] * | 1-15 | |
| A | US 2004/174176 A1 (KIRBY KYLE K [US]) 9 September 2004 (2004-09-09) * figures 1A,2A * * paragraphs [0001], [0052] * | 1-15 | |

-/--

The present search report has been drawn up for all claims

| Place of search | Date of completion of the search | Examiner |
|---|---|---|
| Berlin | 27 November 2008 | Höller, Helmut |

EPO FORM 1503 03.82 (P04C01)

Europäisches
Patentamt

European
Patent Office

Office européen
des brevets

# EUROPEAN SEARCH REPORT

Application Number

EP 08 38 8023

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 99/38232 A (KINETRIX INC [US]; SLOCUM ALEXANDER H [US]; ZIEGENHAGEN R SCOTT III [U) 29 July 1999 (1999-07-29) * figure 9 * * page 15, line 26 - page 16, line 3 * ----- | 1-15 | |

TECHNICAL FIELDS SEARCHED (IPC)

The present search report has been drawn up for all claims

| Place of search | Date of completion of the search | Examiner |
|---|---|---|
| Berlin | 27 November 2008 | Höller, Helmut |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 38 8023

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2008

| Patent document cited in search report | | Publication date | Patent family member(s) | | Publication date |
|---|---|---|---|---|---|
| US 2004056674 | A1 | 25-03-2004 | NONE | | |
| US 2006035404 | A1 | 16-02-2006 | NONE | | |
| US 2002142509 | A1 | 03-10-2002 | JP 2002286758 | A | 03-10-2002 |
| US 5506515 | A | 09-04-1996 | US 5565788 | A | 15-10-1996 |
| US 2006172568 | A1 | 03-08-2006 | JP 2006215022 | A | 17-08-2006 |
| US 2004174176 | A1 | 09-09-2004 | US 2005127928 | A1 | 16-06-2005 |
| WO 9938232 | A | 29-07-1999 | AU 2331299 A<br>TW 396657 B<br>US 5973394 A | | 09-08-1999<br>01-07-2000<br>26-10-1999 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1095282 B1
- US 7304486 B
- US 7323890 B